# EUROPÄISCHE PATENTSCHRIFT

(11) **EP 1 901 360 B1**
(45) Veröffentlichungstag und Bekanntmachung des Hinweises auf die Patenterteilung: **02.04.2014**
(21) Anmeldenummer: 07115265.6
(22) Anmeldetag: 30.08.2007
(51) Int. Cl.: H01L 41/053, F02M 51/06, H01L 41/083

(54) **Piezoaktormodul mit einem ummantelten Piezoaktor**
Piezo actuator module with a cladded piezo actuator
Module de piezoactionneur doté d'un piezoactionneur gainé

(30) Priorität: 14.09.2006 DE 102006043073; 13.04.2007 DE 102007018039
(43) Veröffentlichungstag der Anmeldung: 19.03.2008
(73) Patentinhaber: ROBERT BOSCH GMBH, 70442 Stuttgart (DE)
(72) Erfinder: Heinz, Rudolf, 71272, Renningen (DE); Kienzler, Dieter, 71229, Leonberg (DE); Herwig, Roland, 74354, Besigheim (DE); Schaich, Udo, 70378, Stuttgart (DE)

(56) Entgegenhaltungen:
- WO-A1-2006/128749
- WO-A2-2004/006348
- DE-A1- 10 225 408

## Beschreibung

### Stand der Technik

Die Erfindung betrifft ein von flüssigen Medien umströmtes Piezoaktormodul mit einem ummantelten Piezoaktor, das in einem Piezoinjektor zur zeitpunkt- und mengengenauen Dosierung von Kraftstoff in einem Verbrennungsmotor einsetzbar ist, nach den gattungsgemäßen Merkmalen des Hauptanspruchs.

Ein solcher Piezoinjektor besteht im Wesentlichen aus einem Haltekörper und dem in dem Haltekörper angeordneten Piezoaktormodul, das den zwischen einem Kopf- und Fußteil und Anbindebauteilen angeordneten Piezoaktor aus mehreren übereinandergestapelten Piezoelementen aufweist.

Es ist an sich bekannt, dass zum Aufbau des zuvor erwähnten Piezoaktors Piezoelemente so eingesetzt werden können, dass unter Ausnutzung des sogenannten Piezoeffekts eine Steuerung des Nadelhubes eines Ventils oder dergleichen vorgenommen werden kann. Piezolagen der Piezoelemente sind aus einem Material mit einer geeigneten Kristallstruktur so aufgebaut, dass bei Anlage einer äußeren elektrischen Spannung eine mechanische Reaktion des Piezoelements erfolgt, die in Abhängigkeit von der Kristallstruktur und der Anlagebereiche der elektrischen Spannung einen Druck oder Zug in eine vorgebbare Richtung darstellt. Derartige Piezoaktoren eignen sich beispielsweise für Anwendungen, bei denen Hubbewegungen unter hohen Betätigungskräften und hohen Taktfrequenzen ablaufen.

Beispielsweise ist ein solcher Piezoaktor als Bestandteil eines Piezoinjektors in sogenannten Common Rail Einspritzsystemen (CR-Injektor) aus der DE 10026005 A1 bekannt. Bei diesem Piezoaktor sind ebenfalls Piezoelemente als Stapel angeordnet, der über einen Aktorfuß und einen Aktorkopf unter Vorspannung zwischen zwei Anschlägen gehalten ist. Jede Piezolage ist auch hier zwischen zwei Innenelektroden eingefasst, über die von außen eine elektrische Spannung angelegt werden kann. Aufgrund dieser elektrischen Spannung führen die Piezoelemente dann jeweils kleine Hubbewegungen in Richtung des Potenzialgefälles aus, die sich zum Gesamthub des Piezoaktors addieren. Dieser Gesamthub ist über die Höhe der angelegten Spannung veränderbar und kann auf ein mechanisches Stellglied übertragen werden.

Bei diesen bekannten CR-Injektoren ist eine indirekt vom Piezoaktormodul gesteuerte Düsennadel als Kraftstoffventil vorhanden, wobei der Piezoaktor über eine hub- und temperaturdehnungsausgleichende Hülse-Membran-Anordnung als Ummantelung direkt oder indirekt vom Druck des Kraftstoffs umgeben ist, der in solchen Niederdrucksystemen bei ca. 60 bar liegt und damit eine Realisierung der Öffnungs- und Schließfunktion ermöglicht. Zur Erzielung einer optimalen Auslenkung bei minimalem Platzbedarf müssen die Innenelektroden des Piezoaktors den gesamten Querschnitt des Piezoaktors, bis auf die inaktive Kontaktierungszone, umfassen. Dies bedeutet, dass die Innenelektroden alternierender Polarität an den Seitenflachen der Keramikschichten freiliegen.

Auf CR-Injektoren mit direkter Steuerung der Düsennadel ist dieses bekannte Konzept jedoch nicht ohne weiteres übertragbar, da hier das Piezoaktormodul im Hochdruckbereich des Kraftstoffs betrieben wird und eine starre Hülse-Membran-Anordnung als Ummantelung den hohen Systemdrücken und den höheren Hubbewegungen des Piezoaktors unter den zur Verfugung stehenden Platzverhältnissen im Piezoinjektor nicht standhalten würde.

Aus diesem Grund ist eine elektrische Passivierung dieser Seitenflachen des Piezoaktors sowie die der Kontaktanbauteile zur elektrischen Passivierung des gesamten Piezoaktors notwendig, um ein Unterwandern des Piezoaktors mit den umströmenden Medien und den damit eventuell verbundenen elektrischen Überschlägen oder Kurzschlüssen zwischen benachbarten Innenelektroden zu vermeiden. Diese kann zum Beispiel durch Feuchtigkeit oder die Betriebsstoffe selbst, beispielsweise Diesel, Raps-Metylester, Wasser oder dergleichen, im Betrieb des Piezoaktors hervorgerufen werden.

Um eine elektrische und mechanische Isolierung des Piezoaktors zu erreichen, wird oft auch eine flexible Ummantelung des Piezoaktors vorgeschlagen. Aus der DE 10230032 A1 ist zur Vermeidung der zuvor beschriebenen Nachteile eine Anordnung mit einem Piezoaktormodul in umströmenden Medien bekannt, bei der die Piezoelemente in einer formveränderlichen Isolationsmasse vergossen sind, die wiederum in einem seitlich und am oberen und unteren Ende gegenüber dem Medium verschlossenen Gehäusemantel eingebracht ist.

Die beiden Enden dieses Gehäusemantels können im Bereich ihrer Anlage an den Stahlanbindeteilen des Kopfteils und des Fußteils des Piezoaktormoduls jedoch vom Kraftstoff unterwandert werden und die bekannten Anordnungen bieten somit keinen zuverlässigen Dichtschutz, sodass die einwandfreie Funktion des Piezoaktors über seine Lebensdauer gefährdet ist.

WO 2004/006348 offenbart ein piezoelektrischen Aktor für ihn umströmende Medien, mit einem Piezostapel, der mit direktem Kontakt zumindest bereichsweise innerhalb einer formveränderlichen Isolationsmasse angeordnet ist, die ihrerseits von einem fluidisch verschlossenen Aktorgehäuse umfasst ist, welches von einem Gehäusemantel gebildet wird, der an seinem einem Ende von einem formstabilen Aktordeckel und seinem anderen Ende von einem formstabilen Aktorboden begrenzt ist.

WO 2006/128749 offenbart einen Aktor an dem Übergangsstücke angefügt sind und der umfänglich von einem Dehnschlauch umschlossen ist, wobei der Dehnschlauch in einem Befestigungsbereich mit einem Übergangsstück verbunden ist.

### Offenbarung der Erfindung

Die Erfindung geht von einem eingangs beschriebenen Piezoaktormodul mit Piezoelementen aus, die zwischen einem Kopf- und einem Fußteil eingespannt sind, wobei eine mindestens die Piezoelemente umgebende Hülse als Bestandteil einer Ummantelung vorhanden ist. Erfindungsgemäß ist die Hülse eine Kunststoffhülse, vorzugsweise ein sogenannter Schrumpfschlauch, die am Umfang des zylindrischen Kopf- und/oder Fußteils, in der Regel aus Stahl, des Piezoaktormoduls in ring- förmig verlaufende Vertiefungen fest und dichtend anliegend eingebracht ist.

Bei der Ausführungsform des erfindungsgemäßen Piezoaktormoduls ist bei mindestens einer ringförmig verlaufenden Vertiefungen außen am Umfang der am Kopf- und/oder am Fußteil anliegenden Kunststoffhülse ein Ring mit am Umfang angeordneten Federnasen angebracht, die korrespondierend zu der mindestens einen ringförmig verlaufenden Vertiefungen die Kunststoffhülse in diese Vertiefungen hineindrücken.

Weiterhin ist noch in vorteilhafter Weise vorgesehen, dass die Kunststoffhülse über eine elektrische Isolationsschicht mindestens im Bereich der Piezoelemente am Piezoaktor anliegt.

Bei einer bevorzugten Anwendung der Erfindung ist das Piezoaktormodul Bestandteil eines Piezoinjektors mit direkter Nadelansteuerung für ein Einspritzsystem für Kraftstoff bei einem Verbrennungsmotor, wobei der Kraftstoff unter Hochdruck die Kunststoffhülse umströmt.

Die erfindungsgemäß vorgeschlagene Anbindung der Kunststoffhülse an das Kopf- und Fußteil des Piezoaktormoduls ermöglicht eine zusätzliche radiale Anpressung der Enden der Kunststoffhülse bzw.des Schrumpfschlauchs und eine Kammerung des Schrumpfschlauches über diesen Teilen.

Diese Anordnung gewährleistet somit weitestgehend eine erhöhte Dichtheit des Piezoaktormoduls gegenüber dem umgebenden Kraftstoff auf Lebenszeit, besonders auch bei wechselnden Temperaturen. Beim Aufschrumpfen des Schrumpfschlauches als Kunststoffhülse werden diese Vertiefungen vom Schrumpfschlauch fast vollständig ausgefüllt, wodurch die Kammerung des Schrumpfschlauchs erzielt wird und ebenfalls ein Fließen des Schrumpfschlauches verhindert ist.

Diese besondere Formgebung der Vertiefungen gewährleistet auch eine sichere Abdichtung bei unterschiedlicher Wärmedehnung zwischen dem Kopf- und/oder Fußteil aus Stahl und dem Schrumpfschlauch als Kunststoffhülse. Die durch das federnde Spannelement in Form der Federnasen erzeugte radiale Spannkraft ist nahezu konstant und somit ist eine zusätzliche erhöhte Anpressung des Schrumpfschlauches an der Vertiefung immer vorhanden und die Dichtheit gegeben.

Die Erfindung betrifft ein Piezoaktormodul mit einem zwischen einem Kopf- und einem Fußteil und Anbindebauteile eingespannten Piezoaktor und einer den Piezoaktor umgebenden Umhüllung zur elektrischen Passivierung. Erfindungsgemäß ist in vorteilhafter Weise die Umhüllung eine Isolationsschutzschicht, die mittels einer mechanischen Anbindung an die Anbindebauteile kraft- und/oder formschlüssig angefügt ist.

Die Erfindung schafft somit auf einfache und kostengünstige Weise mittels einer mechanischen Anbindung, mit der die Umhüllung an die Anbindebauteile kraft- und/oder formschlüssig angefügt ist, einen feuchtigkeitsdichten bzw. betriebsstoffdichten und druckdichten Verbund zwischen der elektrischen Passivierung und den Anbindebauteilen an den Stirnflächen des Piezoaktors. Damit wird das Unterwandern von Feuchtigkeit oder Betriebsstoffen zum keramischen Piezoaktor hin vermieden.

Als Ausführungsformen der mechanischen Anbindung kommen beispielsweise montagefreundliche und kostengünstige Normbauteile zur Verwendung, mit den auch eine relativ große Vorspannkraft auf der Isolationsschutzschicht realisierbar ist.

Die Materialen der Isolationsschutzschicht können je nach Anforderung hinsichtlich der Medienbeständigkeit angepasst werden und die Verbindung zum Piezoaktor kann beispielsweise auf einem galvanischen Mehrschichtsystem basieren, das eine Brücke bzw. eine Verbindung der elektrischen Passivierung des Piezoaktors zu den Anbindebauteilen schafft und so vor Feuchtigkeit, den Betriebsstoffen und Druck schützt.

Eine vorteilhafte Anwendung des erfindungemäßen Piezoaktormoduls ergibt sich, wenn das Piezoaktormodul Bestandteil eines Piezoinjektors mit direkter Nadelansteuerung für ein Einspritzsystem für Kraftstoff bei einem Verbrennungsmotor ist, wobei der Kraftstoff unter Hochdruck die Umhüllung umströmt.

### Kurze Beschreibung der Zeichnungen

Ausführungsbeispiele des erfindungsgemäßen Piezoaktormoduls werden anhand der Zeichnung erläutert. Es zeigen:
Figur 1 einen Schnitt durch einen Piezoinjektor mit einem Piezoaktor nach dem Stand der Technik,
Figur 2 ein Beispiel eines Piezoaktors mit einer Spiralfeder und entsprechenden Vertiefungen, die einen Schrumpfschlauch als Kunststoffhülse halten,
Figur 3a bis 3d ein Beispiel nach der Figur 2 im Detail mit gewindeförmigen Vertiefungen und einer Spiralfeder in verschiedenen Ansichten und
Figur 4a bis 4d ein Ausführungsbeispiel mit einer ringförmigen Vertiefung und Federnasen in verschieden Ansichten,
Figur 5 ein weiteres Beispiel der mechanischen Anbindung der umhüllenden Isolationsschutzschicht an die Anbindebauteile mit einer Spiralfeder und
Figur 6 ein anderes Beispiel der mechanischen Anbindung der umhüllenden Isolationsschutzschicht an die Anbindebauteile mit einer Schraubenzugfeder.

### Ausführungsformen der Erfindung

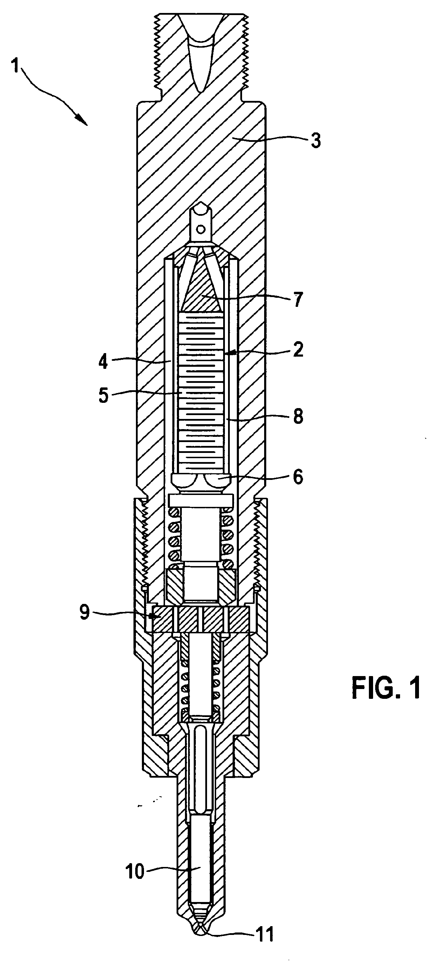

In Figur 1 ist ein prinzipieller Aufbau eines Piezoinjektors 1 mit einem Piezoaktormodul 2 nach dem Stand der Technik gezeigt, der beispielsweise zur Nadelhubsteuerung in einem Einspritzsystem für Kraftstoff bei einem Verbrennungsmotor eingesetzt werden kann. Im oberen Teil ist ein Haltekörper 3 vorhanden, der in seinen geometrischen Abmessungen im Wesentlichen an den jeweiligen Verwendungszweck und den spezifischen Einsatzort angepasst werden kann. Durch den Haltekörper 3 werden mit einer spezifisch angepassten Steckerausführung die elektrische Spannung zur Ansteuerung der in einem Innenraum 4 des Haltekörpers 3 angeordneten Piezoelemente 5 geführt, die zusammen mit einem Kopfteil 6 und einem Fußteil 7 Bestandteil des Piezoaktormoduls 2 sind. Um die Piezoelemente 5 ist eine hier nur schematisch angedeutete isolierende Hülse 8 als Ummantelung gelegt.

Die Piezoelemente 5 wirken als Piezoaktor bei einer Betätigung über eine sich hier senkrecht unterhalb befindliche mechanische Anordnung mit einem Koppler 9 auf eine Düsennadel 10 derart, dass hier eine Freigabe einer Düsenöffnung 11 erfolgen kann. Ein im Inneren des Piezoaktors 1 durch den Innenraum 4 des Haltekörpers 3 geführter Kraftstoff kann somit in den Brennraum eines hier nicht dargestellten Verbrennungsmotors injiziert werden.

Hier können an den Anbindestellen zwischen der Hülse 8 und insbesondere dem Kopfteil 6 und dem Fußteil 7 Unterwanderungen von Kraftstoff zu den Piezoelementen 5 hin ohne weitere Maßnahmen nicht ausgeschlossen werden.

Im Folgenden wird ein Ausführungsbeispiel einer erfindungsgemäßen Anbindungen einer Hülse an entsprechend gestaltete Ausführungen eines Piezoaktormoduls erläutert.

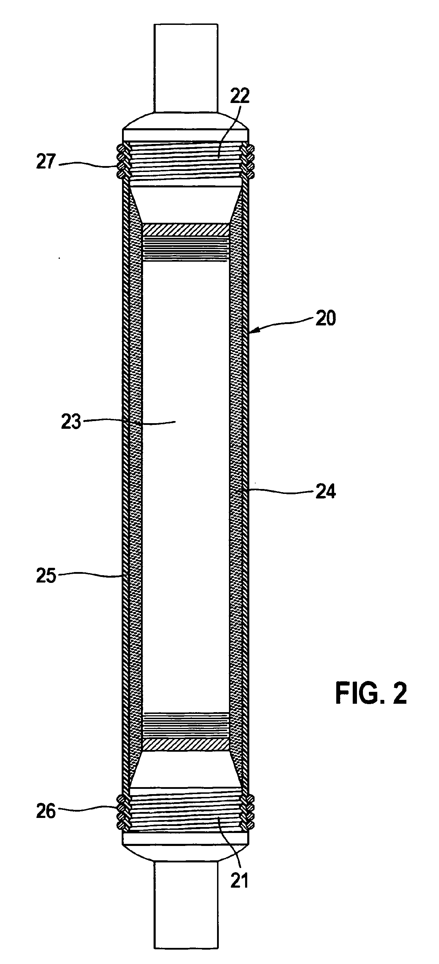

Aus Figur 2 ist ein Beispiel mit einem Piezoaktormodul 20 zu entnehmen, das aus einem Kopfteil 21, einem Fußteil 22 und dazwischen eingebrachten Piezoelementen 23, in etwa entsprechend dem in der Figur 1 gezeigten Piezoaktormodul 2, aufgebaut ist. Hier ist noch eine elektrisch isolierende Elastomerschicht 24 vorhanden, die von einem Schrumpfschlauch als Kunststoffhülse 25 durch Aufschrumpfen eingefasst ist.

An den Anbindestellen der Kunststoffhülse 25 an das Kopfteil 21 und an das Fußteil 22 sind hier jeweils Spiralfedern 26 und 27 als federnde Spannelemente erkennbar, die in entsprechende gewindeförmig verlaufende Vertiefungen am Kopfteil 21 und am Fußteil 22 eingreifen.

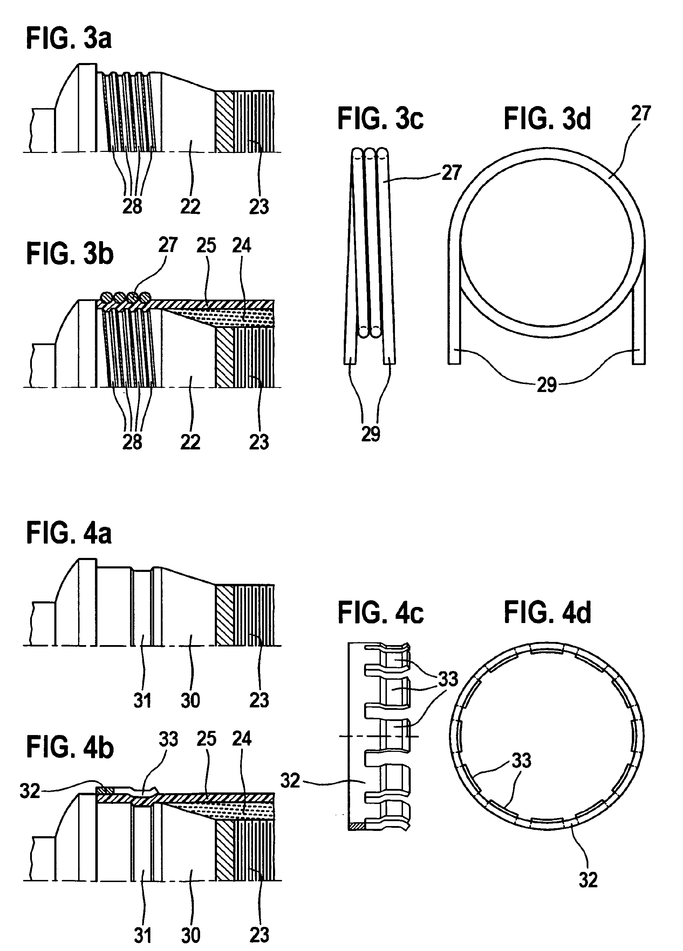

In Figur 3a ist ausschnittweise ein solches Fußteil 22 gezeigt, wobei hier das Kopfteil (21 aus Figur 2) aber identisch ausgebildet ist. Am Umfang des Fußteils 22 nach der Figur 3a sind gewindeförmige Vertiefungen 28 erkennbar. Figur 3b zeigt das Fußteil 22 nach dem Anbinden der Kunststoffhülse 25, wobei hier die außen aufliegende Spiralfeder 27 entsprechend der Figur 2 erkennbar ist, die die Kunststoffhülse 25 hier in die Vertiefungen 28 hineindrückt.

Figur 3c zeigt die Spiralfeder 27 separat in der Seitenansicht und Figur 3d zeigt die Spiralfeder 27 separat in der Draufsicht.

Die Spiralfeder 27 ist, wie aus der Figur 3c ersichtlich, mit zwei Schenkeln 29 versehen, die der Montage dienen. Werden bei der Montage der Spiralfeder 27 die beiden Schenkel 29 auseinandergedrückt, so wird die Spiralfeder 27 im Durchmesser größer und kann an seine Position über die Vertiefungen 28 gebracht werden wo diese nun die zusätzlich benötigte Dichtkraft liefern. Außerdem verhindert die Spiralfeder 27 ein Fließen des Schrumpfschlauches bzw. der Kunststoffhülse 25 nach außen. Die beiden Schenkel 29 der Spiralfeder 27 können nach der Montage abgetrennt werden.

Die Aufschrumpfung des Schrumpfschlauches als Kunststoffhülse 25 bewirkt zunächst schon eine starke Anpressung des Kunststoffes in das Gewindeprofil. Mit steigender Temperatur längt sich der Schrumpfschlauch dabei erheblich mehr als die Stahlrille am Kopfteil 21 oder am Fußteil 22, wodurch eine noch stärkere Anpressung an die Gewindeflanken entsteht. Bei tiefen Temperaturen presst sich der Schrumpfschlauch stärker an die Stahlaußengeometrie des Kopf- oder Fußteils 21,22 an. Somit ist eine sichere Kammerung der Kunststoffhülse 25 im Dichtbereich gegeben und ein Fließen des Kunststoffes verhindert.

Die Spiralfeder 27 nach den Figuren 3a bis 3d ist somit ein radial wirkender Spannring und erzeugt dadurch die benötigte zusätzliche Anpressung der Enden der Kunststoffhülse 25 in das Gewindeprofil der Vertiefungen 28.

In Figur 4a ist abschnittsweise ein Fußteil 30 gemäß eines Ausführungsbeispiels der Erfindung gezeigt, wobei hier das Kopfteil aber ebenfalls identisch ausgebildet ist. Am Umfang des Fußteils 30 nach der Figur 4a ist eine ringförmige Vertiefungen 31 erkennbar. Figur 4b zeigt das Fußteil 30 nach dem Anbinden der Kunststoffhülse 25, wobei hier ein außen aufliegender Ring 32 mit Federnasen 33 vorhanden ist, die die Kunststoffhülse 25 hier in die Vertiefung 31 hineindrücken.

Figur 4c zeigt den Ring 32 mit den Federnasen 33 als zur Spiralfeder 27 nach den Figuren 3a bis 3d alternatives Spannelement separat in der Seitenansicht und Figur 4d zeigt den Ring 32 mit den Federnasen 33 separat in der Draufsicht.

Die Federnasen 33 nach den Figuren 4a bis 4d funktionieren hier als radial wirkende Spannzungen, welche nach der Aufpressung des Ringes 32 auf seine Position gegenüber der umlaufenden Vertiefung 31 am Fußteil 30 oder am Kopfteil die zusätzlich benötigte Dichtkraft durch eine elastische Verformung entsprechend der Spiralfeder 27 nach den Figuren 3a bis 3d bewirken.

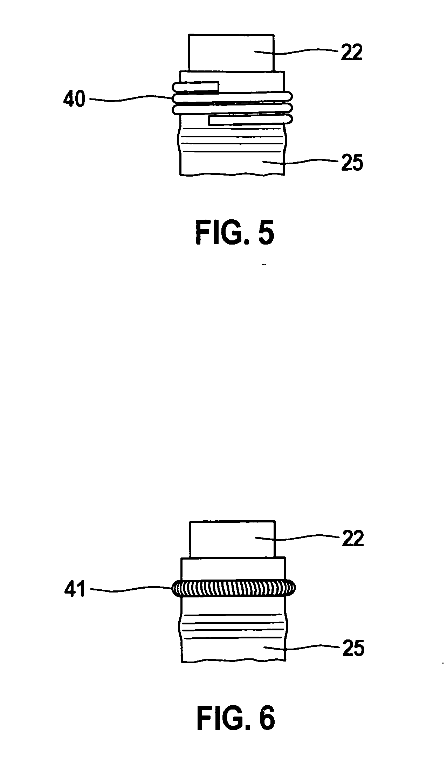

Aus Figur 5 ist zu entnehmen, wie eine kraft- und/oder formschlüssige mechanische Anbindung der umhüllenden Isolationsschutzschicht 25 an das Anbindebauteil 22 mit einer einfachen Spiralfeder 40 eventuell unter Vorspannung erfolgt.

In Figur 6 ist ein weiteres Beispiel gezeigt, bei dem die kraft- und/oder formschlüssige mechanische Anbindung der umhüllenden Isolationsschutzschicht 25 an das Anbindebauteil 22 mit einer aus einer in Radialwellendichtringen verbauten ringförmigen Schraubenzugfeder 41 besteht.

## Patentansprüche

1. Piezoaktormodul (1) mit einem zwischen einem Aktorkopf (6) und einem Aktorfuß (7) eingespannten Piezoaktor und einer den Piezoaktor umgebenden Umhüllung (8) zur elektrischen Passivierung, wobei die Umhüllung eine Isolationsschutzschicht ist, die mittels einer mechanischen Anbindung an Anbindebauteile (21,22) im Bereich der Stirnflächen des Piezoaktors (20) bzw. des Aktorkopfs (6) und/oder des Aktorfußes (7) kraft und/ oder formschlüssig angefügt ist, wobei die Umhüllung eine Kunststoffhülse (25) als Isolationsschicht ist, die am Umfang des zylindrischen Kopf- und/oder Fußteils (21,22;30) des Piezoaktormoduls (20) in ringförmig verlaufende Vertiefungen (28;31) fest und dichtend anliegend eingebracht ist, **dadurch gekennzeichnet, dass** bei mindestens einer ringförmig verlaufenden Vertiefung (31) im Kopf und/ oder am Fußteil (30) des Piezoaktormoduls (20) außen am Umfang der am Kopf- und/oder am Fußteil (30) anliegenden Kunststoffhülse (25) ein Ring (32) mit auf dem Umfang verteilten Fedemasen (33) angebracht ist, die korrespondierend zu der mindestens einen ringförmig verlaufenden Vertiefung (31) die Kunststoffhülse (25) in diese Vertiefung (31) hineindrücken.

2. Piezoaktormodul nach Anspruch 1, **dadurch gekennzeichnet, dass** die Kunststoffhülse (25) aus einem unter Temperatureinwirkung schrumpfenden Material ist.

3. Piezoaktormodul nach einem der vorhergehenden Ansprüche, **dadurch gekennzeichnet, dass** das Kopf- und/oder Fußteil (21,22;30) des Piezoaktormoduls (20) jeweils aus Stahl ist.

4. Piezoaktormodul nach einem der vorhergehenden Ansprüche, **dadurch gekennzeichnet, dass** die Kunststoffhülse (25) über eine elektrische Isolationsschicht (24) mindestens im Bereich der Piezoelemente (23) am Piezoaktormodul (20) anliegt.

5. Piezoaktormodul nach einem der vorhergehenden Ansprüche, **dadurch gekennzeichnet, dass** das Piezoaktormodul (20) Bestandteil eines Piezoinjektors mit direkter Nadelansteuerung für ein Einspritzsystem für Kraftstoff bei einem Verbrennungsmotor ist, wobei der Kraftstoff unter Hochdruck die Kunststoffhülse(25) umströmt.

6. Piezoaktormodul nach einem der vorhergehenden Ansprüche, **dadurch gekennzeichnet, dass** das Piezoaktormodul (1) Bestandteil eines Piezoinjektors mit direkter Nadelansteuerung für ein Einspritzsystem für Kraftstoff bei einem Verbrennungsmotor ist, wobei der Kraftstoff unter Hochdruck die Umhüllung umströmt.

## Claims

1. Piezo actuator module (1) having a piezo actuator braced between an actuator head (6) and an actuator foot (7) and having a casing (8) which surrounds the piezo actuator and which serves for electrical passivation, wherein the casing is an insulating protective layer which, by means of a mechanical connection, is joined in non-positively and/or positively locking fashion to connection components (21, 22) in the region of the end faces of the piezo actuator (20) or of the actuator head (6) and/or of the actuator foot (7), wherein the casing is a plastics sleeve (25) as an insulating layer, which is mounted in a fixed and sealingly abutting manner in annularly running depressions (28; 31) on the circumference of the cylindrical head and/or foot part (21, 22; 30) of the piezo actuator module (20), **characterized in that**, at at least one annularly running depression (31) in the head and/or on the foot part (30) of the piezo actuator module (20), a ring (32) with spring lugs (33) distributed over the circumference is mounted on the outside circumference of the plastics sleeve (25) that bears against the head and/or foot part (30), which spring lugs (33), corresponding to the at least one annularly running depression (31), press the plastics sleeve (25) into said depression (31).

2. Piezo actuator module according to Claim 1, **characterized in that** the plastics sleeve (25) is composed of a material that shrinks under the action of temperature.

3. Piezo actuator module according to one of the preceding claims, **characterized in that** the head and/or foot part (21, 22; 30) of the piezo actuator module (20) is composed in each case of steel.

4. Piezo actuator module according to one of the preceding claims, **characterized in that** the plastics sleeve (25) bears against the piezo actuator module (20) via an electrical insulating layer (24) at least in the region of the piezo elements (23).

5. Piezo actuator module according to one of the preceding claims, **characterized in that** the piezo actuator module (20) is a constituent part of a piezo injector with direct needle actuation for an injection system for fuel in an internal combustion engine, wherein the fuel flows at high pressure around the plastics sleeve (25).

6. Piezo actuator module according to one of the preceding claims, **characterized in that** the piezo actuator module (1) is a constituent part of a piezo injector with direct needle actuation for an injection system for fuel in an internal combustion engine, wherein the fuel flows at high pressure around the casing.

## Revendications

1. Module actionneur piézoélectrique (1) comprenant un actionneur piézoélectrique monté entre une tête d'actionneur (6) et un pied d'actionneur (7) et une enveloppe (8) entourant l'actionneur piézoélectrique pour la passivation électrique, l'enveloppe étant une couche protectrice d'isolation qui est jointe par adhérence et/ou par complémentarité de formes au moyen d'une attache mécanique à des composants d'attache (21, 22) dans la zone des faces frontales de l'actionneur piézoélectrique (20) ou de la tête d'actionneur (6) et/ou du pied d'actionneur (7), l'enveloppe étant une douille en matière plastique (25) faisant office de couche d'isolation qui est insérée sur le pourtour de la partie de tête et/ou de pied (21, 22 ; 30) cylindrique du module actionneur piézoélectrique (20) reposant fermement et en réalisant l'étanchéité dans des enfoncements (28 ; 31) qui s'étendent en forme d'anneau, **caractérisé en ce qu'**au niveau d'au moins un enfoncement (31) qui s'étend en forme d'anneau dans la tête et/ou sur la partie de pied (30) du module actionneur piézoélectrique (20), un anneau (32) muni de tenons flexibles (33) distribués sur le pourtour est monté à l'extérieur sur le pourtour de la douille en matière plastique (25) reposant sur la partie de tête et/ou de pied (30), lesquels, en correspondance avec l'au moins un enfoncement (31) qui s'étend en forme d'anneau, repoussent la douille en matière plastique (25) dans cet enfoncement (31).

2. Module actionneur piézoélectrique selon la revendication 1, **caractérisé en ce que** la douille en matière plastique (25) se compose d'un matériau qui se rétracte sous l'effet de la température.

3. Module actionneur piézoélectrique selon l'une des revendications précédentes, **caractérisé en ce que** la partie de tête et/ou de pied (21, 22 ; 30) du module actionneur piézoélectrique (20) est à chaque fois en acier.

4. Module actionneur piézoélectrique selon l'une des revendications précédentes, **caractérisé en ce que** la douille en matière plastique (25) repose sur le module actionneur piézoélectrique (20) par le biais d'une couche d'isolation électrique (24) au moins dans la zone des éléments piézoélectriques (23).

5. Module actionneur piézoélectrique selon l'une des revendications précédentes, **caractérisé en ce que** le module actionneur piézoélectrique (20) fait partie d'un injecteur piézoélectrique avec commande directe du pointeau pour un système d'injection de carburant sur un moteur à combustion interne, le carburant circulant sous haute pression autour de la douille en matière plastique (25).

6. Module actionneur piézoélectrique selon l'une des revendications précédentes, **caractérisé en ce que** le module actionneur piézoélectrique (1) fait partie d'un injecteur piézoélectrique avec commande directe du pointeau pour un système d'injection de carburant sur un moteur à combustion interne, le carburant circulant sous haute pression autour de l'enveloppe.
